# EUROPÄISCHE PATENTSCHRIFT

(11) **EP 1 770 796 B1**
(45) Veröffentlichungstag und Bekanntmachung des Hinweises auf die Patenterteilung: **12.09.2018**
(21) Anmeldenummer: 06019933.8
(22) Anmeldetag: 22.09.2006
(51) Int. Cl.: H01L 33/48, H01L 33/62, H01L 33/64

(54) **Strahlungsemittierendes Bauelement**
Radiation-emitting component
Composant rayonnant

(30) Priorität: 13.07.2006 DE 102006032416; 29.09.2005 DE 102005046693
(43) Veröffentlichungstag der Anmeldung: 04.04.2007
(73) Patentinhaber: OSRAM Opto Semiconductors GmbH, 93055 Regensburg (DE)
(72) Erfinder: Sorg, Jörg Erich, 93053 Regensburg (DE)
(74) Vertreter: Epping - Hermann - Fischer

(56) Entgegenhaltungen:
- WO-A-2005/064696
- WO-A2-2004/004017
- JP-A- 8 264 841
- JP-A- 11 284 233
- JP-A- 58 147 141
- JP-A- 2000 077 725
- JP-A- 2001 244 508
- JP-A- 2006 080 251
- JP-A- 2006 156 643
- US-A1- 2004 201 028
- US-A1- 2005 128 315
- US-A1- 2006 065 957
- US-B1- 6 344 689
- SCHNITZER I ET AL: "30% EXTERNAL QUANTUM EFFICIENCY FROM SURFACE TEXTURED, THIN-FILM LIGHT-EMITTING DIODES" APPLIED PHYSICS LETTERS, AIP, AMERICAN INSTITUTE OF PHYSICS, MELVILLE, NY, US, Bd. 63, Nr. 16, 18. Oktober 1993 (1993-10-18), Seiten 2174-2176, XP000404433 ISSN: 0003-6951

## Beschreibung

Aus der Offenlegungsschrift DE 31 28 187 A1 ist ein optoelektronisches Bauelement mit einem Halbleiterkörper bekannt, das einen aus Isoliermaterial bestehenden Träger und zwei auf dem Träger flächig aufgebrachte Anschlüsse aufweist, die sich von einer tragenden Außenfläche des Trägers bis auf wenigstens eine weitere Außenfläche des Trägers erstrecken und dort eine Anschlusskontaktfläche bilden. Das Bauelement wird auf einer der tragenden Außenfläche gegenüberliegenden Auflagefläche des Trägers auf eine gedruckte Schaltungsplatte aufgesetzt und durch einen Löt- oder Klebvorgang angeschlossen.

Aus der Offenlegungsschrift DE 102 45 629 A1 ist ein elektronisches Gerät bekannt, bei welchem in Tasten LEDs integriert sind. Die LEDs weisen an einer Unterseite Kontaktpins auf, über welche die LEDs mit einer im elektronischen Gerät angeordneten Platine kontaktiert werden können.

Aus der Offenlegungsschrift WO 2004/004017 A2 ist ein strahlungsemittierendes Bauelement gemäß Oberbegriff des Anspruchs 1 bekannt.

Derzeit handelsübliche LEDs weisen eine Lichtausbeute von mehr als 20 lm/W auf, wobei diese deutlich temperaturabhängig ist. Sie nimmt mit steigender Temperatur ab. Um bei einem Betrieb der LEDs eine durch auftretende Verlustwärme verursachte Temperaturerhöhung und infolgedessen eine Abnahme der Lichtausbeute zu verhindern, ist eine Kühlung der LEDs notwendig.

Bei einem Bauelement, das auf einer Auflagefläche elektrische Anschlüsse aufweist, wobei die Auflagefläche an einer Leiterplatte anliegt, kann ein wesentlicher Teil der im Betrieb erzeugten Wärme über die elektrischen Anschlüsse an die Leiterplatte abgeführt werden. Somit kann das Bauelement über die elektrischen Anschlüsse gekühlt werden. Allerdings ist eine Aufheizung des Bauelements nicht auszuschließen, wenn in der Umgebung des Bauelements weitere wärmeerzeugende Bauteile vorhanden sind, die die erzeugte Wärme an die Leiterplatte abführen.

Bei einem Bauelement, dessen elektrische Anschlüsse über Kontaktpins mit einer Leiterplatte verbunden sind, kann nur ein geringer Teil der Wärme an die Leiterplatte abgegeben werden, wodurch sich das Bauelement leichter aufheizen kann.

Aufgabe der Erfindung ist es, ein strahlungsemittierendes Bauelement mit einer verbesserten Wärmeableitung anzugeben.

Diese Aufgabe wird durch ein strahlungsemittierendes Bauelement mit den Merkmalen des Patentanspruchs 1 gelöst. Vorteilhafte Weiterbildungen der Erfindung sind Gegenstand der abhängigen Ansprüche.

Ein erfindungsgemäßes strahlungsemittierendes Bauelement weist eine Strahlungsquelle, einen Gehäusekörper, eine Strahlungsaustrittsseite, eine der Strahlungsaustrittsseite gegenüber liegende Unterseite, eine die Strahlungsaustrittseite und die Unterseite verbindende Seitenfläche und zumindest einen ersten Kontaktbereich auf, der sich entlang der Seitenfläche erstreckt und Teil eines außerhalb des Gehäusekörpers verlaufenden Trägers ist.

Das strahlungsemittierende Bauelement kann auf der Strahlungsaustrittsseite oder auf der Unterseite montiert sein. Ferner ist es möglich, dass das strahlungsemittierende Bauelement auf der Seitenfläche montiert ist. Bei dieser Anordnung ist das Bauelement vorzugsweise seitlich emittierend und kann dann als Sidelooker bezeichnet werden. Das erfindungsgemäße Bauelement ist somit nicht auf eine einzige Montageart festgelegt und kann daher in einer Vielzahl von Vorrichtungen Verwendung finden.

Um eine strahlungsaustrittsseitige Montage des Bauelements zu ermöglichen, ist das strahlungsemittierende Bauelement auf der Strahlungsaustrittsseite so ausgebildet, dass es leicht an ein weiteres Bauteil angebracht werden kann.

Vorzugsweise ist das Bauelement auf der Strahlungsaustrittsseite zumindest teilweise eben ausgebildet, so dass das Bauelement in das weitere Bauteil beispielsweise eingeklebt werden kann.

Des Weiteren kann das strahlungsemittierende Bauelement so ausgebildet sein, dass es auf der Strahlungsaustrittsseite in ein weiteres Bauteil eingesteckt, eingeklemmt oder eingerastet werden kann.

Um eine unterseitige Montage des Bauelements zu ermöglichen, wird das Bauelement auf der Unterseite vorzugsweise durch eine ebene Auflagefläche begrenzt, die elektrische Anschlüsse aufweist. Insbesondere ist für die unterseitige Montage ein SMD (Surface Mount Device)-Bauelement geeignet. Vorteilhafterweise kann die Bestückung von SMD-Bauelementen in Serie und damit kostengünstig erfolgen.

Ferner ist die Seitenfläche des Bauelements im Wesentlichen eben ausgebildet. Dies bedeutet, dass die Seitenfläche zumindest stellenweise leicht gekrümmt sein kann. Eine im Wesentlichen ebene Ausbildung der Seitenfläche ermöglicht eine einfache Montage des Bauelements, beispielsweise auf einer Leiterplatte.

Gemäß einer bevorzugten Ausführungsform ist die Seitenfläche für einen thermischen Anschluss des Bauelements vorgesehen. Dazu ist der erste Kontaktbereich, der sich entlang der Seitenfläche erstreckt, thermisch leitend ausgebildet. Besonders bevorzugt ist der erste Kontaktbereich zur Kühlung des strahlungsemittierenden Bauelements mit einem Kühlkörper, zum Beispiel einem Kühlblech, verbunden. Jede Seitenfläche des Bauelements, darüber hinaus auch die Außenfläche auf der Strahlungsaustritts- oder Unterseite, kann zumindest einen ersten Kontaktbereich aufweisen, an den die im Betrieb erzeugte Wärme von der Strahlungsquelle abgeleitet werden kann.

Der Gehäusekörper beziehungsweise das strahlungsemittierende Bauelement ist dabei so aufgebaut, dass ein effektiver Wärmeabtransport von der Strahlungsquelle zum ersten Kontaktbereich erfolgen kann. Beispielsweise kann entlang einer Außenwand des Gehäusekörpers eine thermisch leitende Bahn verlaufen, die die Strahlungsquelle direkt mit dem ersten Kontaktbereich verbindet.

Bei einer bevorzugten Ausführungsform ist der erste Kontaktbereich als laschenförmiger Teilbereich des Trägers ausgebildet. Dieser laschenförmige Teilbereich verjüngt sich weiter bevorzugt am Übergang zum restlichen Träger. Die Laschenform des ersten Kontaktbereichs ermöglicht nach der Herstellung des Trägers eine einfache Weiterbearbeitung des Trägers, beispielsweise eine Biegung des ersten Kontaktbereichs am Übergang.

Die Biegung kann so vorgenommen sein, dass der erste Kontaktbereich aus einer sich entlang der Unterseite erstreckenden Ebene herausgebogen ist.

Vorteilhafterweise kann ein derartig gebogener Träger den Gehäusekörper umgreifen, wodurch der Gehäusekörper im Träger mechanisch fixiert und so eine laterale Verschiebung des Trägers verhindert wird.

Das strahlungsemittierende Bauelement weist zumindest einen zweiten Kontaktbereich auf, der sich entlang der Unterseite des strahlungsemittierenden Bauelements erstreckt. Dieser zweite Kontaktbereich ist vorzugsweise elektrisch leitend.

Eine funktionelle Unterteilung der leitenden Bereiche in den ersten Kontaktbereich, der thermisch leitend ist, und in den zweiten Kontaktbereich, der elektrisch leitend ist, hat den Vorteil, dass die Kühlung des Bauelements außer über die elektrischen Anschlüsse, die durch die zweiten Kontaktbereiche realisiert sind, über einen separaten thermischen Anschluss, der durch den ersten Kontaktbereich realisiert ist, erfolgen kann.

Darüber hinaus kann der erste Kontaktbereich zusätzlich elektrisch leitend sein. Vorteilhafterweise können dadurch der erste und der zweite Kontaktbereich in einem Element zusammengefasst werden. Somit kann der zweite Kontaktbereich als ein weiterer Teilbereich des Trägers ausgebildet sein.

Ferner kann das strahlungsemittierende Bauelement mehrere zweite Kontaktbereiche aufweisen.

Vorzugsweise ist der Träger zweiteilig ausgeführt, so dass durch einen ersten Teilträger ein erster elektrischer Anschluss und durch einen zweiten Teilträger ein zweiter elektrischer Anschluss gebildet ist. Besonders bevorzugt umfassen die beiden Teilträger jeweils zumindest einen ersten Kontaktbereich und zumindest einen zweiten Kontaktbereich.

Bei einer bevorzugten Ausführungsform ist der Träger elektrisch und thermisch leitend. Die thermische und elektrische Leitfähigkeit des Trägers kann dadurch erreicht werden, dass der Träger ein Metall und/oder eine Metall-Verbindung enthält. Vorzugsweise enthält der Träger eine Kupfer-Legierung, beispielsweise eine Kupfer-NickelLegierung.

Der Träger kann besonders einfach als Stanzteil hergestellt sein.

Bei einer bevorzugten Ausführungsform umfasst die Strahlungsquelle mindestens einen strahlungsemittierenden Halbleiterchip. Besonders bevorzugt ist der strahlungsemittierende Halbleiterchip ein Dünnfilm-Halbleiterchip.

Ein Dünnfilm-Halbleiterchip zeichnet sich insbesondere durch mindestens eines der folgenden charakteristischen Merkmale aus:
- An einer zu einem Trägerelement hingewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 pm oder weniger, insbesondere im Bereich von 10 pm auf; und
- die Epitaxieschichtenfolge enthält mindestens eine Halbleiterschicht mit zumindest einer Fläche die eine Durchmischungsstruktur aufweist, die im Idealfall zu einer annähernd ergodischen Verteilung des Lichtes in der epitaktischen Epitaxieschichtenfolge führt, das heißt sie weist ein möglichst ergodisch stochastisches Streuverhalten auf.

Ein Grundprinzip eines Dünnfilm-Halbleiterchips ist beispielsweise in I. Schnitzer et al., Appl. Phys. Lett. 63 (16), 18. Oktober 1993, 2174-2176 beschrieben, deren Offenbarungsgehalt insofern hiermit durch Rückbezug aufgenommen wird.

Ein strahlungsemittierender Dünnfilm-Halbleiterchip ist in guter Näherung ein Lambert'scher Oberflächenstrahler und eignet sich daher besonders gut für die Anwendung in einem elektronischen Gerät, beispielsweise als Blitzlicht in einem Mobiltelefon, etwa mit einer integrierten Kamera.

Der Halbleiterchip kann je nach Wellenlänge auf der Basis von verschiedenen Halbleitermaterialsystemen hergestellt sein.
Für eine langwellige Strahlung ist zum Beispiel ein Halbleiterkörper auf der Basis von InₓGa_{y}Al_{1-x-y}As, für sichtbare rote bis gelbe Strahlung zum Beispiel ein Halbleiterkörper auf Basis von InₓGa_{y}Al_{1-x-y}P und für kurzwellige sichtbare (grün bis blau) oder UV-Strahlung zum Beispiel ein Halbleiterkörper auf der Basis von InₓGa_{y}Al_{1-x-y}N geeignet, wobei gilt 0 ≤ x ≤ 1 und 0 ≤ y ≤ 1.

Vorzugsweise ist die Strahlungsquelle auf dem Träger angeordnet. Der Träger weist dafür einen Montagebereich beziehungsweise einen Chipmontagebereich auf. Zweckmäßigerweise ist der Chipmontagebereich auf einer der Unterseite gegenüberliegenden Seite des Trägers vorgesehen. Ferner kann der Träger auf dieser Seite einen Chipanschlussbereich aufweisen, mit dem der Halbleiterchip, beispielsweise mittels eines Bonddrahts, verbunden ist.

Die im Betrieb des strahlungsemittierenden Bauelements erzeugte Wärme kann dadurch abtransportiert werden, dass der Chipmontagebereich mit einem der ersten Kontaktbereiche thermisch leitend verbunden ist.

Vorzugsweise ist der Chipmontagebereich ein Teilbereich des zweiten Kontaktbereichs des ersten Teilträgers und ist mit einem oder mehreren der ersten Kontaktbereiche des ersten Teilträgers direkt verbunden.

Außerdem kann der Chipanschlussbereich ein Teilbereich des zweiten Kontaktbereichs des zweiten Teilträgers sein.

Bei einer bevorzugten Ausführungsform wird die Strahlungsquelle als Blitzlicht betrieben. In diesem Fall weist sie einen strahlungsemittierenden Dünnfilm-Halbleiterkörper auf, der vorzugsweise Pulse einer Dauer zwischen 300 und 400 ms aussendet, wobei die Pulse im 3s-Takt aufeinander folgen. Ein herkömmliches, unzureichend gekühltes Bauelement würde sich dabei stark erwärmen. Im Rahmen der Erfindung kann dies durch den thermischen Anschluss des Bauelements an einen Kühlkörper verhindert werden. Dies hat den Vorteil, dass die Intensität der von dem Dünnfilm-Halbleiterkörper erzeugten Strahlung annähernd konstant bleibt.

Neben dem strahlungsemittierenden Halbleiterchip kann, insbesondere bei einem gepulsten Betrieb, auf dem Chipmontagebereich ein ESD (electro static discharge)-Halbleiterchip angeordnet sein. Typischerweise sind die beiden Halbleiterchips antiparallel verschaltet.

Ist der strahlungsemittierende Halbleiterchip ein Dünnfilm-Halbleiterchip, so kann dieser als Flip-Chip p-seitig montiert sein, während der ESD-Halbleiterchip in herkömmlicher Weise n-seitig montiert ist.

Die von der Strahlungsquelle beziehungsweise von dem Halbleiterchip emittierte Strahlung ist nicht auf eine einzige Wellenlänge festgelegt. Vielmehr kann durch ein Konversionselement, das der Strahlungsquelle in Abstrahlrichtung nachgeordnet ist, die Wellenlänge der von der Strahlungsquelle erzeugten Strahlung zumindest teilweise konvertiert werden. Typischerweise absorbiert das Konversionselement zumindest einen Teil der vom Halbleiterchip emittierten Strahlung und emittiert daraufhin bevorzugt Strahlung einer größeren Wellenlänge als die Wellenlänge der Strahlung, die ursprünglich von dem Halbleiterkörper emittiert wurde. Eine resultierende Strahlung ergibt sich durch Mischung des wellenlängenkonvertierten Anteils der Strahlung mit der von dem Halbleiterchip ursprünglich ausgesandten Strahlung. Dadurch kann mischfarbiges Licht, vorzugsweise weißes Licht, erzeugt werden.

Ferner kann mischfarbiges Licht erzeugt werden, indem für die Strahlungsquelle mindestens zwei Halbleiterchips verwendet werden, die Licht verschiedener Wellenlänge emittieren und deren Licht wahlweise gemischt wird.

Vorzugsweise ist zwischen dem Träger, der den Gehäusekörper beispielsweise umgreift, und dem Gehäusekörper eine elektrisch isolierende Schicht angeordnet. Diese weist Öffnungen für auf dem Träger angeordnete Elemente, beispielsweise die Strahlungsquelle, auf. Vorteilhafterweise kann diese Schicht die beiden Teilträger miteinander verbinden, wenn der Träger zweiteilig ausgebildet ist. Besonders bevorzugt enthält die elektrisch isolierende Schicht ein Kunststoffmaterial. Dieses Kunststoffmaterial kann beispielsweise glasfaserverstärkt sein.

Die Strahlungsquelle kann von dem Gehäusekörper umschlossen werden. Dadurch kann die Strahlungsquelle vor Beschädigungen, die beispielsweise durch von außen kommende mechanische oder thermische Einwirkungen hervorgerufen werden, geschützt werden.

Ferner kann der Gehäusekörper in Abstrahlrichtung ein strahlrichtendes beziehungsweise -formendes Element aufweisen. Die Abstrahlcharakteristik der Strahlungsquelle kann dadurch vorteilhafterweise beeinflusst werden. Beispielsweise können diese Elemente ein Reflektor beziehungsweise eine Linse sein.

Bei einer bevorzugten Ausführungsform ist das strahlrichtende beziehungsweise -formende Element mit dem Gehäusekörper einstückig ausgebildet. Beispielsweise können das strahlrichtende- beziehungsweise formende Element und der Gehäusekörper mittels eines Spritzgusses hergestellt sein.

Bei einem SMD-Bauelement ist darauf zu achten, dass die für das strahlformende Element und für den Gehäusekörper verwendeten Materialien löt-tauglich sind, das heißt, dass sich die verwendeten Materialien beim Löten, wobei Temperaturen von circa 260°C auftreten können, nicht verändern. Geeignete Materialien sind zum Beispiel ein Epoxidharz, ein auf Silikon basierendes Material, eine Mischung von Epoxid- und Silikonharzen, ein Hochtemperatur-Thermoplast oder ein Duroplast.

Das erfindungsgemäße strahlungsemittierende Bauelement kann für ein elektronisches Gerät verwendet werden. Es hat den Vorteil, dass es eine geringe Bautiefe, beispielsweise 2mm, aufweist, wodurch es für ein elektronisches Gerät wie beispielsweise ein PDA (Personal Digital Assistant), eine Digitalkamera oder ein Mobiltelefon, die ebenfalls eine geringe Bautiefe aufweisen sollen, besonders geeignet ist. Ferner hat es den Vorteil, dass der thermische Anschluss unabhängig von dem elektrischen Anschluss ausgeführt sein kann.

Bei einem bevorzugten Ausführungsbeispiel eines elektronischen Geräts wird das strahlungsemittierende Bauelement als Blitzlicht in einer Kamera eines Mobiltelefons, vorzugsweise mit Wechselstrom betrieben. Ein derartiges Blitzlicht benötigt im Gegensatz zu einer herkömmlichen Entladungslampe keine Aufladezeit. Ferner kann das strahlungsemittierende Bauelement mit Gleichstrom betrieben werden. In diesem Fall ist das Bauelement beispielsweise als Filmleuchte für Videokameras besonders geeignet.

Ferner kann das erfindungsgemäße Bauelement gut gekühlt werden, da an die ersten Kontaktbereiche ein Kühlkörper beziehungsweise eine Wärmesenke angeschlossen werden kann. Vorzugsweise enthält dieser Kühlkörper ein Metall. Aber auch ein Keramikmaterial ist denkbar.

Alternativ kann der Kühlkörper an die zweiten Kontaktbereiche angeschlossen werden, während der elektrische Anschluss über die ersten Kontaktbereiche erfolgt. Es versteht sich, dass der Kühlkörper derart angeordnet ist, dass im Betrieb kein Kurzschluss auftritt.

Mittels einer geeigneten optischen Anordnung, beispielsweise einer Kombination des in dem strahlungsemittierenden Bauelement angeordneten strahlrichtenden beziehungsweise -formenden Elements und einem beispielsweise trichterförmig ausgebildeten Fenster des elektronischen Geräts, in dem das strahlungsemittierende Bauelement angeordnet beziehungsweise dem das strahlungsemittierende Bauelement in Abstrahlrichtung vorgelagert ist, kann außerdem eine vorteilhaft homogene Ausleuchtung erzielt werden. Beispielsweise kann der Blitzlicht-Halbleiterchip bei einer Entfernung von circa 1m etwa ein Feld der Größe 0,87m x 1,15m ausleuchten.

Weitere Merkmale, Vorteile und Weiterbildungen der Erfindung ergeben sich aus den nachfolgend in Verbindung mit den Figuren 1 bis 5 erläuterten Ausführungsbeispielen. In den Figuren sind gleiche beziehungsweise gleich wirkende Bestandteile mit denselben Bezugszeichen versehen.

Es zeigen:
- Figur 1: eine schematische, perspektivische Ansicht eines Ausführungsbeispiels eines erfindungsgemäßen strahlungsemittierenden Bauelements,
- Figur 2: eine schematische, perspektivische Ansicht der Unterseite des erfindungsgemäßen Bauelements entsprechend dem Ausführungsbeispiel,
- Figur 3: eine schematische, perspektivische Schnittansicht des erfindungsgemäßen Bauelements entsprechend dem Ausführungsbeispiel,
- Figur 4: eine Schnittansicht eines ersten Ausführungsbeispiels eines elektronischen Gerätes,
- Figur 5: eine Schnittansicht eines zweiten Ausführungsbeispiels eines elektronischen Geräts,
- Figur 6: eine Seitenansicht eines auf der Seitenfläche montierten erfindungsgemäßen Bauelements.

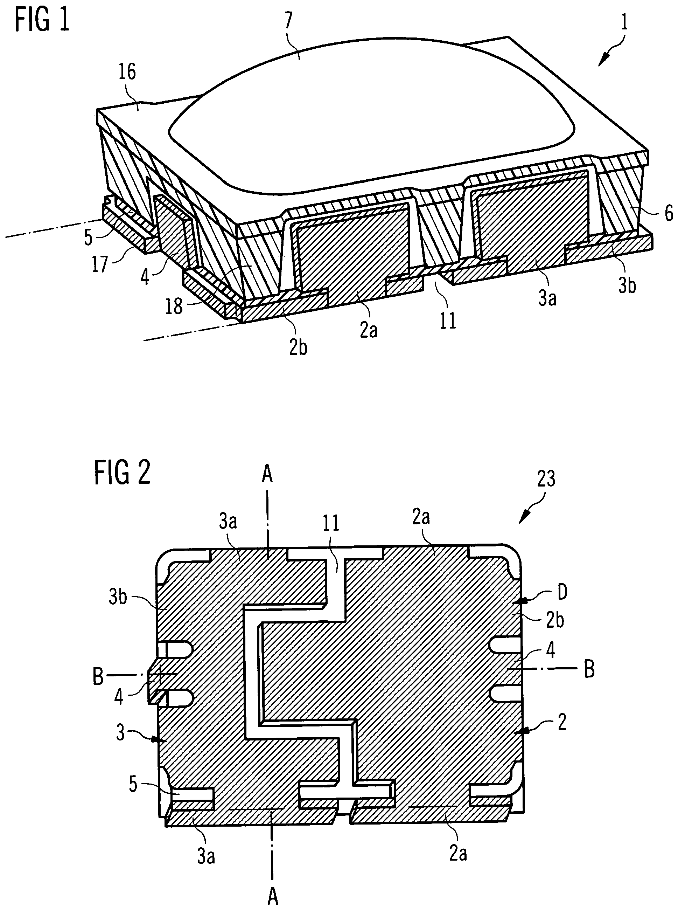

Figur 1 zeigt schematisch ein erfindungsgemäßes strahlungsemittierendes Bauelement 1. Dieses umfasst eine Linse 7, die von einem Gehäusekörper 6 getragen wird. Der Gehäusekörper 6 ist auf einem zweiteilig ausgebildeten Träger 23 (s. Figur 2) mit einem Teilträger 2 und einem Teilträger 3 (s. Figur 2) angeordnet, die durch den Schlitz 11 voneinander getrennt sind.

Die beiden Teilträger 2, 3 sind jeweils aus einem Stanzteil hergestellt.

Der Teilträger 2 weist einen ersten Kontaktbereich 2a und einen zweiten Kontaktbereich 2b auf. Entsprechend weist der Teilträger 3 einen ersten Kontaktbereich 3a und einen zweiten Kontaktbereich 3b auf. Die ersten Kontaktbereiche 2a und 3a sind thermisch leitend und erstrecken sich entlang einer Seitenfläche 18. Außerdem erstrecken sich zwei weitere erste Kontaktbereiche entlang der dieser Seitenfläche gegenüberliegenden Seitenfläche. Die zweiten Kontaktbereiche 2b und 3b sind elektrisch leitend.

Weitere Kontaktbereiche 4, die sich entlang der Seitenflächen erstrecken, können wahlweise mit einem Kühlkörper oder einer elektrischen Energieversorgung verbunden sein.

Der Gehäusekörper 6 weist nischenartige Einbuchtungen auf, in welche die ersten Kontaktbereiche 2a, 3a und die Kontaktbereiche 4 eingreifen. Somit stehen die Kontaktbereiche gegenüber dem Gehäusekörper 6 nicht hervor.

Die beiden Teilträger 2, 3 sind durch eine elektrisch isolierende Schicht 5 miteinander verbunden und bilden den Träger 23 (s. Figur 2), der den Gehäusekörper 6 umgreift. Der Gehäusekörper 6 ist somit mechanisch fixiert.

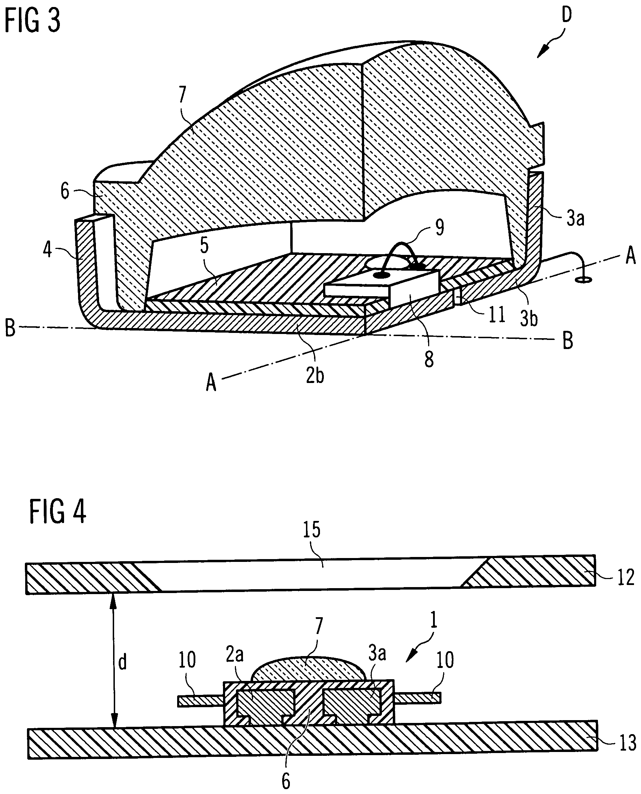

Vorzugsweise ist ein strahlungsemittierender Halbleiterchip 8 (s. Figur 3) auf dem zweiten Kontaktbereich 2b angeordnet. Dieser ist vorteilhafterweise mit dem ersten Kontaktbereich 2a thermisch leitend verbunden, so dass die im Betrieb entstehende Wärme vom Halbleiterchip 8 über den ersten Kontaktbereich 2a abgeleitet werden kann.

In Figur 2 ist die Unterseite 17 des in Figur 1 dargestellten strahlungsemittierenden Bauelements 1 dargestellt. Auf der Unterseite 17 ist der Träger 23 angeordnet, der die durch den Schlitz 11 getrennten beiden Teilträger 2 und 3 umfasst.
Die Kontaktbereiche 4, 2a und 2b sind einstückig ausgebildet. Ferner sind die Kontaktbereiche 4, 3a und 3b einstückig ausgebildet.

Der Träger 23 ist nach Art einer Schale geformt, in die die elektrisch isolierende Schicht 5 eingelegt werden kann. Ferner kann in diese Art Schale der Gehäusekörper passgenau eingebracht werden. Die beiden Teilträger 2, 3 können durch die elektrisch isolierende Schicht 5 zusammengehalten werden. Die Linien A-A und B-B begrenzen einen Teil D des strahlungsemittierenden Bauelements 1, der in Figur 3 dargestellt ist.

In der in Figur 3 gezeigten Schnittansicht des strahlungsemittierenden Bauelements 1 sind die Linse 7 und der Gehäusekörper 6 einstückig ausgebildet dargestellt. Der Gehäusekörper 6 ist im Wesentlichen sockelartig ausgebildet.
Die Linse 7 ist wie ein gewölbter Aufsatz auf dem Gehäusekörper 6 angeordnet. Vorteilhafterweise kann durch die Höhe des Gehäusekörpers 6 der Abstand zwischen dem strahlungsemittierenden Halbleiterchip 8 und der Linse 7 in geeigneter Weise eingestellt werden.

Der zweite Kontaktbereich 2b weist einen Chipmontagebereich auf, auf dem der Halbleiterchip 8 montiert ist. Ausgehend vom Halbleiterchip 8 verläuft ein Bonddraht 9 zum zweiten Kontaktbereich 3b. Die elektrisch isolierende Schicht 5 weist Öffnungen für den Halbleiterchip 8 und den Bonddraht 9 auf.

In Figur 4 ist ein Ausschnitt aus einem elektronischen Gerät, beispielsweise einem Mobiltelefon, in einer Querschnittansicht dargestellt. Zu sehen sind eine Oberschale 12 und eine Unterschale 13 des Gerätegehäuses. In der Unterschale 13 ist eine Leiterplatte integriert, auf der das strahlungsemittierende Bauelement 1 unterseitig angeordnet ist. Vorzugsweise ist dieses auf die Leiterplatte gelötet.

Das strahlungsemittierende Bauelement 1 ist über die unterseitig angeordneten zweiten Kontaktbereiche elektrisch angeschlossen. Über diese zweiten Kontaktbereiche kann auch die im Betrieb erzeugte Wärme an die Leiterplatte abgeführt werden.

Zur zusätzlichen Kühlung sind an die Kontaktbereiche 4 Kühlkörper 10 angebracht. Ferner können Kühlkörper an den Kontaktbereichen 2a und 3a angebracht sein. Eine derartige Kühlung ist vor allem dann vorteilhaft, wenn die Strahlungsquelle als Blitzlicht betrieben wird. Wie eine Simulation gezeigt hat, kann sich ein Bauelement im Laufe von 20 Pulsen auf über 200°C erhitzen, wenn keine zusätzliche Kühlung erfolgt. Dabei sendet das Blitzlicht Pulse einer Dauer zwischen 300 und 400 ms aus, wobei die Pulse im 3s-Takt aufeinander folgen.

Für eine homogene Ausleuchtung eines zu beleuchtenden Feldes kann durch eine geeignete optische Anordnung gesorgt werden. Dabei ist der Abstand d zwischen der Oberschale 12 und der Unterschale 13 zu berücksichtigen. Die optische Anordnung setzt sich besonders bevorzugt aus einer Linse 7, die Teil des strahlungsemittierenden Bauelements 1 ist, und einem trichterförmig ausgebildeten, gegebenenfalls verspiegelten Fenster 15 in der Oberschale 12 zusammen.

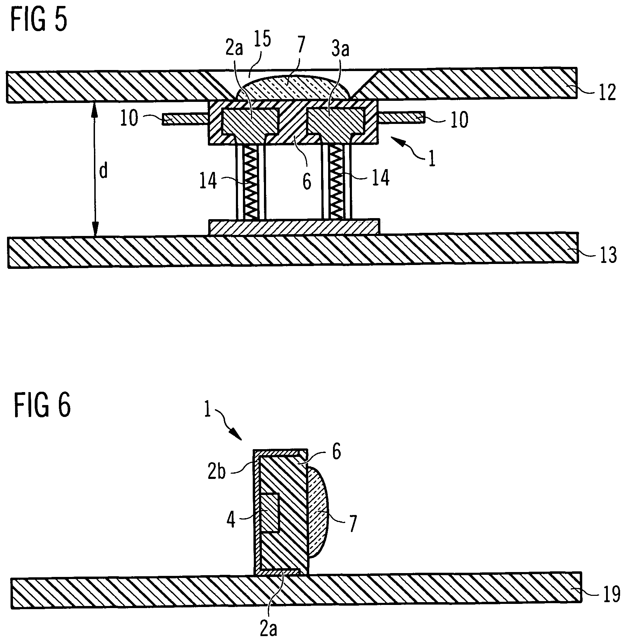

In Figur 5 ist eine alternative Ausführungsform des in Figur 4 dargestellten elektronischen Gerätes gezeigt. Dabei ist das strahlungsemittierende Bauelement 1 auf einer Strahlungsaustrittsseite 16 (s. Figur 1) montiert und wird von der Oberschale 12 gehalten.

Vorteilhafterweise ist für eine geeignete optische Anordnung der Abstand d zwischen der Oberschale 12 und der Unterschale 13 irrelevant, da die Linse 7 in das Fenster 15 hineinragt und die von der Strahlungsquelle emittierte Strahlung direkt in das Fenster 15 eingekoppelt wird.

Während die Strahlung mittels der Linse 7 gebündelt werden kann, können mittels des als Reflektor ausgebildeten Fensters 15 Absorptionsverluste reduziert werden, so dass insgesamt durch die optische Anordnung die Intensität der in einem Strahlungskegel emittierten Strahlung erhöht werden kann.

Der elektrische Anschluss des strahlungsemittierenden Bauelements 1 erfolgt nach wie vor über die in der Unterschale 13 integrierte Leiterplatte. Allerdings stehen die zweiten Kontaktbereiche nicht in unmittelbarem Kontakt mit der Leiterplatte. Vielmehr dienen flexible Kontakte 14, vorzugsweise Kontaktfedern, als Verbindung zwischen den zweiten Kontaktbereichen und der Leiterplatte. Ein derartiger elektrischer Anschluss hat den Vorteil, dass mittels der flexiblen Kontakte 14 jeder beliebige Abstand d überbrückbar ist.

Allerdings ist durch die flexiblen Kontakte 14, die typischerweise einen geringen Durchmesser aufweisen, eine ausreichende Kühlung des Bauelements 1 schwer möglich. Da sich jedoch bei dem erfindungsgemäßen Bauelement 1 entlang der Seitenflächen die Kontaktbereiche 2a, 3a und 4 erstrecken, die mit den Kühlkörpern 10 (für die Kontaktbereiche 2a, 3a nicht gezeigt) verbunden sind, kann dadurch eine effiziente Kühlung erfolgen.

Das in Figur 6 dargestellte strahlungsemittierende Bauelement 1 kann als Sidelooker bezeichnet werden. Die Abstrahlung erfolgt in lateraler Richtung, parallel zur Haupterstreckungsrichtung einer Leiterplatte 19.

Als Montagefläche kann die Seitenfläche 18 (s. Figur 1) dienen, wobei das Bauelement mittels des ersten Kontaktbereichs 2a und des ersten Kontaktbereichs 3a (nicht dargestellt), die sich entlang der Seitenfläche 18 (s. Figur 1) erstrecken, elektrisch anschließbar ist.

Eine Kühlung des Bauelements kann bei dieser Ausführung über die Kontaktbereiche 4 und/oder den zweiten Kontaktbereich 2b und den zweiten Kontaktbereich 3b (nicht dargestellt) erfolgen.

## Patentansprüche

1. Strahlungsemittierendes Bauelement (1) mit
- einer Strahlungsquelle,
- einem Gehäusekörper (6),
- einer Strahlungsaustrittsseite (16),
- einer der Strahlungsaustrittsseite (16) gegenüberliegenden Unterseite (17),
- einer die Strahlungsaustrittsseite (16) und die Unterseite (17) verbindenden Seitenfläche (18),
- zumindest einem ersten Kontaktbereich (2a, 3a), wobei der erste Kontaktbereich (2a, 3a) als Teilbereich eines außerhalb des Gehäusekörpers (6) verlaufenden Trägers (23) ausgebildet ist,
der Träger zweiteilig ausgebildet ist und eine zwischen den Trägerteilen (2,3) und dem Gehäusekörper angeordnete elektrisch isolierende Schicht (5) die beiden Trägerteile (2,3) miteinander verbindet,
**dadurch gekennzeichnet, dass**
sich der erste Kontaktbereich (2a, 3a) entlang der Seitenfläche (18) erstreckt und thermisch leitend ausgebildet ist.

2. Strahlungsemittierendes Bauelement (1) nach Anspruch 1, wobei
das Bauelement (1) auf der Strahlungsaustrittsseite (16) montiert ist.

3. Strahlungsemittierendes Bauelement nach Anspruch 1, wobei das Bauelement (1) auf der Unterseite (17) montiert ist.

4. Strahlungsemittierendes Bauelement nach Anspruch 1, wobei das Bauelement (1) auf der Seitenfläche (18) montiert ist.

5. Strahlungsemittierendes Bauelement (1) nach einem der vorhergehenden Ansprüche, wobei die Seitenfläche (18) für einen thermischen Anschluss des Bauelements (1) vorgesehen ist.

6. Strahlungsemittierendes Bauelement (1) nach einem der vorhergehenden Ansprüche, wobei
der erste Kontaktbereich (2a, 3a) als laschenförmiger Teilbereich des Trägers (23) ausgebildet ist.

7. Strahlungsemittierendes Bauelement (1) nach einem der vorhergehenden Ansprüche, wobei
der erste Kontaktbereich (2a, 3a) aus einer sich entlang der Unterseite (17) erstreckenden Ebene herausgebogen ist.

8. Strahlungsemittierendes Bauelement (1) nach einem der vorhergehenden Ansprüche, das
zumindest einen zweiten Kontaktbereich (2b, 3b) aufweist, der sich entlang der Unterseite (17) erstreckt.

9. Strahlungsemittierendes Bauelement (1) nach Anspruch 8, wobei
der zweite Kontaktbereich (2b, 3b) elektrisch leitend ist.

10. Strahlungsemittierendes Bauelement (1) nach Anspruch 8 oder 9, wobei
der zweite Kontaktbereich (2b, 3b) als Teilbereich des Trägers (23) ausgebildet ist.

11. Strahlungsemittierendes Bauelement (1) nach einem der vorhergehenden Ansprüche,
wobei der Träger (23) thermisch und elektrisch leitend ist.

12. Strahlungsemittierendes Bauelement (1) nach einem der vorhergehenden Ansprüche, wobei
der Träger (23) ein Metall und/oder eine Metall-Verbindung enthält.

13. Strahlungsemittierendes Bauelement (1) nach dem vorherigen Anspruch, wobei
die Metall-Verbindung eine Kupfer-Legierung ist.

14. Strahlungsemittierendes Bauelement (1) nach einem der vorhergehenden Ansprüche, wobei
die Strahlungsquelle zumindest einen strahlungsemittierenden Halbleiterchip (8) umfasst.

15. Strahlungsemittierendes Bauelement (1) nach dem vorherigen Anspruch, wobei
der strahlungsemittierende Halbleiterchip (8) ein Dünnfilm-Halbleiterchip ist.

16. Strahlungsemittierendes Bauelement (1) nach Anspruch 14 oder 15, wobei
der Träger (23) einen Chipmontagebereich für den Halbleiterchip (8) aufweist.

17. Strahlungsemittierendes Bauelement (1) nach dem vorherigen Anspruch, wobei
der Chipmontagebereich mit dem ersten Kontaktbereich (2a) thermisch leitend verbunden ist.

18. Strahlungsemittierendes Bauelement (1) nach Anspruch 16 oder 17, wobei
der Chipmontagebereich ein Teilbereich des zweiten Kontaktbereichs (2b) ist.

19. Strahlungsemittierendes Bauelement (1) nach einem der Ansprüche 14 bis 18, wobei
der Träger (23) einen Chipanschlussbereich für den Halbleiterchip (8) aufweist.

20. Strahlungsemittierendes Bauelement (1) nach dem vorherigen Anspruch, wobei
der Chipanschlussbereich ein Teilbereich des zweiten Kontaktbereichs (3b) ist.

21. Strahlungsemittierendes Bauelement (1) nach einem der vorhergehenden Ansprüche, wobei
die Strahlungsquelle als Blitzlicht betrieben wird.

22. Strahlungsemittierendes Bauelement (1) nach einem der vorhergehenden Ansprüche, wobei
der Strahlungsquelle in Abstrahlrichtung ein Konversionselement nachgeordnet ist, das von der Strahlungsquelle emittierte Strahlung einer ersten Wellenlänge zumindest teilweise in Strahlung einer von der ersten Wellenlänge verschiedenen zweiten Wellenlänge konvertiert.

23. Strahlungsemittierendes Bauelement (1) nach Anspruch 1, wobei
die elektrisch isolierende Schicht (5) ein Kunststoffmaterial enthält.

24. Strahlungsemittierendes Bauelement (1) nach einem der vorhergehenden Ansprüche, wobei
der Strahlungsquelle ein strahlformendes Element nachgeordnet ist.

25. Strahlungsemittierendes Bauelement (1) nach Anspruch 24, wobei
das strahlformende Element mit dem Gehäusekörper (6) einstückig ausgebildet ist.

26. Strahlungsemittierendes Bauelement (1) nach Anspruch 24, wobei
der Gehäusekörper sockelartig ausgebildet ist und das strahlformende Element eine Linse (7) ist, welche nach Art eines gewölbten Aufsatzes auf dem Gehäusekörper (6) angeordnet ist.

27. Strahlungsemittierendes Bauelement (1) nach Anspruch 1, wobei
der Träger (23) nach Art einer Schale geformt ist, in welche die elektrisch isolierende Schicht (5) eingelegt ist.

28. Elektronisches Gerät mit einem strahlungsemittierenden Bauelement (1) gemäß einem der Ansprüche 1 bis 27, wobei der erste Kontaktbereich (2a, 3a) mit einem Kühlkörper (10) verbunden ist.

29. Elektronisches Gerät nach Anspruch 28, wobei
der zweite Kontaktbereich (2b, 3b) elektrisch angeschlossen ist.

30. Elektronisches Gerät nach Anspruch 28 oder 29, wobei
das elektronische Gerät ein PDA, eine Digitalkamera oder ein Mobiltelefon, insbesondere mit integrierter Kamera, ist.

31. Elektronisches Gerät nach Anspruch 30, wobei
das strahlungsemittierende Bauelement (1) für einen Blitzlicht-Betrieb vorgesehen ist.

32. Elektronisches Gerät nach Anspruch 30, wobei
das strahlungsemittierende Bauelement (1) für einen kontinuierlichen Betrieb, vorzugsweise als Filmleuchte, vorgesehen ist.

## Claims

1. Radiation-emitting component (1) with
- a radiation source,
- a housing body (6),
- a radiation exit side (16),
- an underside (17) which is opposite the radiation exit side (16),
- a side surface (18) connecting the radiation exit side (16) and the underside (17),
- at least a first contact region (2a, 3a), wherein
the first contact region (2a, 3a) is formed as a subregion of a carrier (23), said carrier extending outside the housing body (6),
the carrier comprises two parts and an electrically insulating layer (5) arranged between the carrier parts (2, 3) and the housing body connects the two carrier parts (2, 3) with each other,
**characterized in that**
the first contact region (2a, 3a) extends along the side surface (18) and is thermally conductive.

2. Radiation-emitting component (1) according to claim 1, wherein
the component (1) is mounted on the radiation exit side (16).

3. Radiation-emitting component according to claim 1, wherein the component (1) is mounted on the underside (17).

4. Radiation-emitting component according to claim 1, wherein the component (1) is mounted on the side surface (18).

5. Radiation-emitting component (1) according to one of the preceding claims, wherein the side surface (18) is provide for a thermal connection of the component (1).

6. Radiation-emitting component (1) according to one of the preceding claims, wherein
the first contact region (2a, 3a) is formed as a flap-shaped subregion of the carrier (23).

7. Radiation-emitting component (1) according to one of the preceding claims, wherein
the first contact region (2a, 3a) is bent out of a plane extending along the underside (17).

8. Radiation-emitting component (1) according to one of the preceding claims, which
comprises at least one second contact region (2b, 3b) extending along the underside (17).

9. Radiation-emitting component (1) according to claim 8, wherein
the second contact region (2b, 3b) is electrically conductive.

10. Radiation-emitting component (1) according to claim 8 or 9, wherein
the second contact region (2b, 3b) is formed as a subregion of the carrier (23).

11. Radiation-emitting component (1) according to one of the preceding claims,
wherein the carrier (23) is thermally and electrically conductive.

12. Radiation-emitting component (1) according to one of the preceding claims, wherein
the carrier (23) contains a metal and/or a metal compound.

13. Radiation-emitting component (1) according to the preceding claim, wherein
the metal compound is a copper alloy.

14. Radiation-emitting component (1) according to one of the preceding claims, wherein
the radiation source comprises at least one radiation-emitting semiconductor chip (8).

15. Radiation-emitting component (1) according to the preceding claim, wherein
the radiation-emitting semiconductor chip (8) is a thin-film semiconductor chip.

16. Radiation-emitting component (1) according to claim 14 or 15, wherein
the carrier (23) has a chip mounting region for the semiconductor chip (8).

17. Radiation-emitting component (1) according to the preceding claim, wherein
the chip mounting region is thermally conductively connected to the first contact region (2a).

18. Radiation-emitting component (1) according to claim 16 or 17, wherein
the chip mounting region is a subregion of the second contact region (2b).

19. A radiation-emitting component (1) according to any one of claims 14 to 18, wherein
the carrier (23) has a chip connection region for the semiconductor chip (8).

20. Radiation-emitting component (1) according to the preceding claim, wherein
the chip connection region is a subregion of the second contact region (3b).

21. Radiation-emitting component (1) according to one of the preceding claims, wherein
the radiation source is operated as a flash.

22. Radiation-emitting component (1) according to one of the preceding claims, wherein
a conversion element is located downstream of the radiation source, said conversion element at least partially converts radiation of a first wavelength emitted by the radiation source into radiation of a second wavelength different from the first wavelength.

23. Radiation-emitting component (1) according to claim 1, wherein
the electrically insulating layer (5) contains a plastic material.

24. Radiation-emitting component (1) according to one of the preceding claims, wherein
a beam-shaping element is arranged downstream of the radiation source.

25. Radiation-emitting component (1) according to claim 24, wherein
the beam-shaping element is integrally formed with the housing body (6).

26. Radiation-emitting component (1) according to claim 24, wherein
the housing body is formed like a pedestal and the beam-shaping element is a lens (7) which is arranged in the manner of a curved attachment on the housing body (6).

27. Radiation-emitting component (1) according to claim 1, wherein
the carrier (23) is shaped in the manner of a shell, in which the electrically insulating layer (5) is inserted.

28. An electronic device with a radiation-emitting component (1) according to one of claims 1 to 27, wherein
the first contact region (2a, 3a) is connected to a heat sink (10) .

29. Electronic device according to claim 28, wherein
the second contact region (2b, 3b) is electrically connected.

30. Electronic device according to claim 28 or 29, wherein the electronic device is a PDA, a digital camera or a mobile phone, in particular with an integrated camera.

31. Electronic device according to claim 30, wherein
the radiation-emitting component (1) is provided for a flash operation.

32. Electronic device according to claim 30, wherein the radiation-emitting component (1) is provided for continuous operation, preferably as a film light.

## Revendications

1. Composant émetteur de rayonnement (1) comportant
- une source de rayonnement,
- un corps de boîtier (6),
- une face de sortie de rayonnement (16),
- une face inférieure (17) opposée à la face de sortie de rayonnement (16),
- une face latérale (18) reliant la face de sortie de rayonnement (16) à la face inférieure (17),
- au moins une première zone de contact (2a, 3a), la première zone de contact (2a, 3a) constituant un secteur partiel d'un support s'étendant à l'extérieur du corps de boîtier (6),
le support étant conformé en deux parties, et une couche (5) électriquement isolante prévue entre les parties du support (2, 3) et le corps de boîtier reliant les deux parties du support (2, 3), **caractérisé en ce que**
la première zone de contact (2a, 3a) s'étend le long de la face latérale (18) et est conçue de manière thermiquement conductrice.

2. Composant émetteur de rayonnement (1) selon la revendication 1, dans lequel le composant (1) est monté à la face de sortie de rayonnement (16).

3. Composant émetteur de rayonnement selon la revendication 1, dans lequel le composant (1) est monté à la face inférieure (17).

4. Composant émetteur de rayonnement selon la revendication 1, dans lequel le composant (1) est monté à la face latérale (18) .

5. Composant émetteur de rayonnement (1) selon une des revendications précédentes, la face latérale (18) étant prévue pour un raccordement thermique du composant (1).

6. Composant émetteur de rayonnement (1) selon une des revendications précédentes, dans lequel la première zone de contact (2a, 3a) est prévue comme secteur partiel du support (23), sous forme de languette.

7. Composant émetteur de rayonnement (1) selon une des revendications précédentes, dans lequel la première zone de contact (2a, 3a) est cintrée depuis un plan s'étendant depuis la face inférieure (17).

8. Composant émetteur de rayonnement (1) selon une des revendications précédentes comprenant au moins une deuxième zone de contact (2b, 3b) s'étendant le long de la face inférieure (17).

9. Composant émetteur de rayonnement (1) selon la revendication 8, dans lequel la seconde zone de contact (2b, 3b) est électriquement conductrice.

10. Composant émetteur de rayonnement (1) selon la revendication 8 ou 9, dans lequel la seconde zone de contact (2b, 3b) est prévue comme section partielle du support (23).

11. Composant émetteur de rayonnement (1) selon une des revendications précédentes, dans lequel le support (23) est thermiquement et électriquement conducteur.

12. Composant émetteur de rayonnement (1) selon une des revendications précédentes, dans lequel le support (23) contient un métal et/ou un composé métallique.

13. Composant émetteur de rayonnement (1) selon la revendication précédente, dans lequel le composé métallique est un alliage de cuivre.

14. Composant émetteur de rayonnement (1) selon une des revendications précédentes, dans lequel la source de rayonnement comporte au moins une puce semi-conductrice émettant un rayonnement (8).

15. Composant émetteur de rayonnement (1) selon la revendication précédente, dans lequel la puce semi-conductrice émettant un rayonnement (8) est une puce semi-conductrice à couche mince.

16. Composant émetteur de rayonnement (1) selon la revendication 14 ou 15, dans lequel le support (23) présente une zone de montage de puce pour le montage de la puce semi-conductrice (8).

17. Composant émetteur de rayonnement (1) selon la revendication précédente, dans lequel la zone de montage de la puce est reliée de façon thermiquement conductrice à la première zone de contact (2a).

18. Composant émetteur de rayonnement (1) selon la revendication 16 ou 17, dans lequel la zone de montage de la puce constitue une section partielle de la seconde zone de contact (2b).

19. Composant émetteur de rayonnement (1) selon l'une des revendications 14 à 18, dans lequel le support (23) présente une zone de raccordement pour la puce semi-conductrice (8).

20. Composant émetteur de rayonnement (1) selon la revendication précédente, dans lequel la zone de montage de la puce constitue une section partielle de la seconde zone de contact (3b).

21. Composant émetteur de rayonnement (1) selon une des revendications précédentes, dans lequel la source de rayonnement est utilisée comme flash.

22. Composant émetteur de rayonnement (1) selon une des revendications précédentes, dans lequel un élément de conversion est disposé en aval de la source de rayonnement, dans la direction d'émission, l'élément de conversion convertissant le rayonnement d'une première longueur d'onde émis par la source de rayonnement au moins partiellement en un rayonnement d'une seconde longueur d'onde différant de la première longueur d'onde.

23. Composant émetteur de rayonnement (1) selon la revendication 1, dans lequel la couche électriquement isolante (5) contient une matière plastique.

24. Composant émetteur de rayonnement (1) selon une des revendications précédentes, dans lequel un élément de formage de rayon est disposé en aval de la source de rayonnement.

25. Composant émetteur de rayonnement (1) selon la revendication 24, dans lequel l'élément de formage de rayon est intégralement formé avec le corps de boîtier (6).

26. Composant émetteur de rayonnement (1) selon la revendication 24, dans lequel le corps de boîtier est prévu sous forme d'un socle et l'élément de formage de rayon étant une lentille (7) disposée sur le corps de boîtier (6) à la manière d'un capot cintré.

27. Composant émetteur de rayonnement (1) selon la revendication 1, dans lequel le support (23) est constitué à la manière d'une cuve dans laquelle est insérée la couche électriquement isolante (5).

28. Dispositif électronique comprenant un composant émetteur de rayonnement (1) selon l'une des revendications 1 à 27, dans lequel la première zone de contact (2a, 3a) est associée à un corps de refroidissement (10).

29. Dispositif électronique selon la revendication 28, dans lequel la seconde zone de contact (2b, 3b) est raccordée électriquement.

30. Dispositif électronique selon la revendication 28 ou 29, dans lequel le dispositif électronique est un PDA, un appareil photographique numérique ou un téléphone mobile, comprenant en particulier une caméra intégrée.

31. Dispositif électronique selon la revendication 30, dans lequel le composant émetteur de rayonnement (1) est prévu pour fonctionner en service flash.

32. Dispositif électronique selon la revendication 30, dans lequel le composant émetteur de rayonnement (1) est prévu pour fonctionner en continu, de préférence comme éclairage d'un film.
